# EUROPÄISCHE PATENTSCHRIFT

(11) **EP 3 186 842 B1**
(45) Veröffentlichungstag und Bekanntmachung des Hinweises auf die Patenterteilung: **01.07.2020**
(21) Anmeldenummer: 15744150.2
(22) Anmeldetag: 21.07.2015
(51) Int. Cl.: H01L 41/083, H01L 41/338

(54) **VERFAHREN ZUR HERSTELLUNG VON KERAMISCHEN VIELSCHICHTBAUELEMENTEN UND KERAMISCHES VIELSCHICHTBAUELEMENT**
METHOD FOR PRODUCING CERAMIC MULTI-LAYER COMPONENTS AND CERAMIC MULTI-LAYER COMPONENT
PROCÉDÉ DE FABRICATION DE COMPOSANTS MULTICOUCHES EN CÉRAMIQUE ET COMPOSANT MULTICOUCHE EN CÉRAMIQUE

(30) Priorität: 26.08.2014 DE 102014112207
(43) Veröffentlichungstag der Anmeldung: 05.07.2017
(73) Patentinhaber: TDK Electronics AG, 81671 München (DE)
(72) Erfinder: OTTLINGER, Marion, A-8530 Deutschlandsberg (AT); WINDISCH, Peter, A-8530 Deutschlandsberg (AT); KRUMPHALS, Robert, A-8530 Deutschlandsberg (AT); REINISCH, Manfred, A-8522 Gr. St. Florian (AT); GALLER, Martin, A-8401 Kalsdorf (AT); KÜGERL, Georg, A-8552 Eibiswald (AT)
(74) Vertreter: Epping - Hermann - Fischer
(86) Internationale Anmeldenummer: PCT/EP2015/066655
(87) Internationale Veröffentlichungsnummer: WO 2016/030085

(56) Entgegenhaltungen:
- WO-A1-2011/015403
- DE-A1- 10 215 993
- DE-A1-102005 030 109
- US-A- 5 692 280
- US-A1- 2002 005 680
- US-A1- 2003 098 632

## Beschreibung

Die vorliegende Erfindung betrifft ein Verfahren zur Herstellung von keramischen Vielschichtbauelementen.

Beispiele aus dem Stand der Technik finden sich in Patentschriften WO2011/015403 und US5692280.

Eine zu lösende Aufgabe ist es, ein verbessertes keramisches Vielschichtbauelement sowie ein Verfahren zu dessen Herstellung anzugeben.

Diese Aufgabe wird durch das Verfahren mit den Merkmalen des Patentanspruchs 1 gelöst.

Es wird ein Verfahren zur Herstellung von keramischen Vielschichtbauelementen angegeben. Das Verfahren umfasst das Bereitstellen von Grünschichten für die keramischen Vielschichtbauelemente, das Stapeln der Grünschichten zu einem Stapel und anschließendes Pressen des Stapels zu einem Block, das Vereinzeln des Blocks in Teilblöcke mit jeweils einer Längsrichtung, das thermisches Behandeln der Teilblöcke und anschließendes mechanisches Bearbeiten von Oberflächen der Teilblöcke, wobei bei dem mechanischen Bearbeiten Vertiefungen an den Oberflächen der Teilblöcke gefertigt werden, und das Vereinzeln der Teilblöcke entlang der Vertiefungen.

Dabei können die Schritte in der hier angegebenen Reihenfolge nacheinander vorgenommen werden. Das Verfahren ermöglicht es also, zahlreiche Schritte des Herstellungsverfahrens vorzunehmen, bevor die Vielschichtbauelemente, die in einem Teilblock zusammengefasst sind, vereinzelt werden. Der Aufwand, der für das Herstellungsverfahren zu betreiben ist, wird durch das Vornehmen des Vereinzelns zu einem späten Zeitpunkt in dem Verfahren erheblich reduziert, da Verfahrensschritte, in denen Teilblöcke behandelt werden, gegenüber Verfahrensschritte, in denen einzelne Vielschichtbauelemente behandelt werden, auf Grund des geringeren Zahl von zu behandelnden separaten Teilen wesentlich einfacher durchzuführen sind.

Durch das Bilden der Vertiefungen in den Oberflächen der Teilblöcke während des Herstellungsverfahrens können Vielschichtbauelemente gefertigt werden, die sich durch eine besonders gute Bauraumausnutzung bei einen kreiszylindrischen Bauraum eignen. Es werden so Vielschichtbauelemente gefertigt, deren Form an die Form des kreiszylindrischen Einbauraums gut angenähert ist.

Insbesondere ist es nicht erforderlich, die Form jedes Vielschichtbauelement einzeln zu modifizieren, beispielsweise durch ein Abschneiden der Ecken nach dem Vereinzeln. Das oben angegebene Verfahren ermöglicht es vielmehr, eine Vielzahl von Vielschichtbauelementen an den späteren Einbauraum anzupassen, während diese noch in einem Teilblock zusammengefasst sind. Dadurch sind sie, wie oben beschrieben, deutlich leichter zu handhaben als dies für vereinzelte Vielschichtbauelemente der Fall wäre.

Das Verfahren bietet darüber hinaus weitere Vorteile. Der Verzug, den ein Vielschichtbauelement beim thermischen Behandeln mittels Sintern erfährt, ist umso größer je kleiner der Querschnitt des Bauelements ist. Die thermische Behandlung wird hier am unvereinzelten Teilblock vorgenommen, so dass der Verzug recht gering ist. Dadurch kann ein übermäßiger Verwurf von verzogenen Vielschichtbauelementen und ein erhöhter Schleifaufwand zum Ausgleichen des Verzugs vermieden werden.

Das Risiko von mechanischen Beschädigungen, beispielsweise dem Abbrechen von Kanten, der einzelnen Vielschichtbauelemente wird erheblich reduziert, da die Teilblöcke erst in einem sehr späten Verfahrenszeitpunkt vereinzelt werden.

Das Verfahren kann so ausgestaltet sein, dass die Schnittflächen, entlang denen die Teilblöcke vereinzelt werden, die Anforderungen an die Oberflächenqualität der Vielschichtbauelemente bereits erfüllen. Daher ist keine weitere Bearbeitung der Schnittflächen erforderlich. Dies kann sowohl auf die Schnittflächen, entlang denen der Block in Teilblöcke vereinzelt wird, als auch auf die Schnittflächen, entlang denen die Teilblöcke in Vielschichtbauelemente vereinzelt werden, zutreffen.

Insbesondere kann eine Vereinzelung durch Schneiden des Teilblocks mit einer sehr hohen Präzision durchgeführt werden. Dementsprechend ermöglicht es das Vereinzeln durch Schneiden, sehr enge Toleranzgrenzen für die Abmessungen der Vielschichtbauelemente einzuhalten. Auf diese Weise kann eine sehr gute Einhaltung von Prozesskontrollparametern, wie beispielsweise cpk-Werten, erreicht werden.

Das Verfahren kann mit einem geringen Materialverlust durchgeführt werden. Insbesondere ist es nicht erforderlich, jedes Vielschichtbauelement nach dem Vereinzeln weiter zu bearbeiten, beispielsweise abzuschleifen, so dass es hier nicht zu Materialverlust kommt.

Das Verfahren kann ferner weitere Schritte aufweisen, beispielsweise das Aufbringen von Außenkontaktierungen auf den Teilblöcken, wobei die Außenkontaktierung für die Kontaktierung der gefertigten Vielschichtbauelemente sorgt. Bei den keramischen Vielschichtbauelementen kann es sich insbesondere um piezoelektrische Vielschichtbauelemente, beispielsweise piezoelektrische Aktuatoren, handeln.

Die Oberflächen können die Oberflächen der Seitenflächen des Teilblocks, die Oberfläche der Oberseite des Teilblocks und/oder die Oberfläche der Unterseite des Teilblocks sein. Dabei können sich die Ober- und Unterseite in einer Stapelrichtung des Blocks gegenüberliegen. Die Seitenflächen können ferner so angeordnet sein, dass ihre jeweilige Flächennormale senkrecht zur Stapelrichtung ist.

Die Längsrichtung kann senkrecht zu der Stapelrichtung sein.

Ferner können die Teilblöcke entlang der Vertiefungen vereinzelt werden. Dabei können die Vertiefungen so angeordnet sein, dass sie die Form der Vielschichtbauelemente, die durch das Vereinzeln aus den Teilblöcken gefertigt werden, mitbestimmen. Insbesondere können die Vertiefungen zu einer Form der Vielschichtbauelemente führen, bei denen die Ecken einer Grundfläche abgeschnitten sind. Dadurch können die Vielschichtbauelemente gut an den jeweiligen Einbauraum angepasst werden. Es können beispielsweise Vielschichtbauelemente gefertigt werden, die gut an einen kreiszylindrischen Einbauraum abgepasst sind.

Ferner können sich die bei dem mechanischen Bearbeiten erzeugten Vertiefungen in eine Richtung quer zu der Längsrichtung erstrecken. Auch diese Ausgestaltung der Vertiefungen kann zu einer verbesserten Anpassung der Vielschichtbauelemente an einen bestimmten Einbauraum beitragen.

Bei dem mechanischen Bearbeiten können die Vertiefungen in den Oberflächen der Teilblöcke durch Schleifen erzeugt werden. Insbesondere können bei dem mechanischen Bearbeiten die Oberflächen der Teilblöcke flächig abgeschliffen werden und im gleichen Verfahrensschritt die Vertiefungen in den Oberflächen der Teilblöcke durch Schleifen erzeugt werden. Somit entsteht für das Erzeugen der Vertiefungen in den Oberflächen kein wesentlicher Mehraufwand.

Die Grünschichten können nach dem thermischen Behandeln in jedem Teilblock übereinander angeordnete keramische Schichten und dazwischen angeordnete erste und zweite elektrisch leitfähige Schichten ausbilden. Insbesondere können die Grünschichten durch einen Sinterprozess in die keramische Schichten und die dazwischen angeordneten elektrisch leitfähige Schichten umgewandelt werden. Ferner können die Teilblöcke nach dem mechanischen Bearbeiten der Oberflächen selektiv geätzt werden, wobei Material von den ersten elektrisch leitfähigen Schichten auf einer ersten Seitenfläche des Teilblocks und in den in der ersten Seitenfläche gefertigten Vertiefungen bei dem selektiven Ätzen abgetragen wird und Material von den zweiten elektrisch leitfähigen Schichten auf einer zweiten Seitenfläche des Teilblocks und in den in der zweiten Seitenfläche gefertigten Vertiefungen bei dem selektiven Ätzen abgetragen wird.

Durch diesen Ätzprozess können Isolationszonen ausgebildet werden. Insbesondere kann bei dem Ätzprozess Material in den jeweiligen Vertiefungen abgetragen werden. Dementsprechend können die Isolationszonen auch in den Bereichen der Vertiefungen im Zustand des Teilblocks gebildet werden. Es sind somit keine weiteren Verarbeitungsschritte zur Ausbildung der Isolationszonen in abgeschnittenen Ecken nach dem Vereinzeln des Teilblocks erforderlich.

Der Ätzprozess wirkt in den Vertiefungen genauso wie auf den Seitenflächen des Teilblocks.

Durch das Vereinzeln der Teilblöcke entlang der Vertiefungen entstehen scharfe Kanten. Die scharfen Kante entstehen dabei an den Stellen, an der eine Seitenfläche, die vor dem Vereinzeln mechanisch bearbeitet wurde, auf eine Seitenfläche stößt, die bei dem Vereinzeln eine Schnittfläche darstellt, entlang der zwei Vielschichtbauelemente getrennt wurden. Das oben beschriebene selektive Ätzen der Teilblöcke vor dem Vereinzeln sorgt dafür, dass die scharfe Kante in einer Isolationszonen liegt. Entlang der scharfen Kante ist somit Material entweder der ersten leitfähigen Schicht oder der zweiten leitfähigen Schicht abgetragen. Die durch das Vereinzeln entstandenen scharfen Kanten sind somit elektrisch passive geschaltet. Da scharfe Kanten anfälliger für mechanische Beschädigungen sind als dies bei abgerundeten Kanten der Fall ist, ist es vorteilhaft, wenn die scharfen Kanten in einer Isolationszone liegen. Wird die scharfe Kante mechanisch beschädigt, so wird dadurch die Funktionsweise des Vielschichtbauelements nicht beeinträchtigt, wenn die scharfe Kante in einer Isolationszone liegt.

Ferner können die Vertiefungen V-förmig sein. Durch das Ausbilden V-förmiger Vertiefungen in den Teilblöcken, können zylinderförmige Vielschichtbauelemente mit einer achteckigen Grundfläche gefertigt werden, die gut an einen kreiszylindrischen Einbauraum angepasst sind.

Die Vertiefungen können derart geformt sein, dass die entstehenden Kanten leicht abgerundet sind. Insbesondere können bei V-förmigen Vertiefungen sowohl die Spitze des V als auch die Randbereiche, in denen die Vertiefungen auslaufen, abgerundet ausgestaltet sein.

Mit dem erfinderischen Verfahren wird ein keramisches Vielschichtbauelement vorgeschlagen, das einen Grundkörper mit übereinander angeordneten keramischen Schichten und dazwischen angeordneten elektrisch leitfähige Schichten aufweist, wobei der Grundkörper eine Grundfläche aufweist, die die Form eines Rechtecks mit abgeschnittenen Ecken hat. Ein solches Vielschichtbauelement ist besonders gut an einen kreiszylindrischen Einbauraum angepasst.

Ein solches Vielschichtbauelement kann mit dem oben beschriebenen Verfahren gefertigt werden, wobei erst zu einem sehr späten Verfahrenszeitpunkt eine Vereinzelung der Teilblöcke in Vielschichtbauelemente vorgenommen wird, so dass sich die oben beschriebenen Vorteile ergeben, beispielsweise ein reduzierter Herstellungsaufwand.

Die Grundfläche des Grundkörpers ist vorzugsweise achteckig.

Das Rechteck, dessen Form die Grundfläche aufweist, kann vier Seitenflächen aufweisen, wobei jede der elektrisch leitfähigen Schichten an einer der Seitenflächen und in den an die Seitenfläche angrenzenden abgeschnittenen Ecken von einer Außenseite des Grundkörpers beabstandet ist und in den übrigen Seitenflächen sowie den übrigen abgeschnittenen Ecken an die Außenseite des Grundkörpers heranreicht.

Das keramische Vielschichtbauelement kann ein piezoelektrisches Vielschichtbauelement, beziehungsweise ein piezoelektrischer Aktuator, sein.

Die elektrisch leitfähigen Schichten können zumindest eines der Materialien Kupfer, Silber und Silber-Palladium aufweisen. Insbesondere können die elektrisch leitfähigen Schichten aus einem dieser Materialien bestehen.

Weitere Vorteile, vorteilhafte Ausgestaltungen und Zweckmäßigkeiten der Erfindung ergeben sich aus der folgenden Beschreibung der Ausführungsbeispiele in Verbindung mit den Figuren.
- Figur 1: zeigt schematisch einen Block von mit elektrisch leitfähigen Schichten versehenen Grünschichten.
- Figur 2: zeigt schematisch einen Teilblock, welcher aus dem Block vereinzelt wurde.
- Figur 3: zeigt den Teilblocks nachdem Oberflächen des Teilblocks mechanisch bearbeitet wurden.
- Figur 4: zeigt einen Querschnitt durch den in Figur 3 gezeigten Teilblock.
- Figur 5: zeigt einen weiteren Querschnitt durch den in Figur 3 gezeigten Teilblock, wobei der Querschnitt durch eine zur Querschnittsebene der Figur 4 benachbarte Ebene verläuft.
- Figur 6: zeigt ein Vereinzeln des Teilblocks in Vielschichtbauelemente.
- Figur 7: zeigt ein Vielschichtbauelement nach Abschluss des Herstellungsverfahrens in perspektivischer Ansicht.

Die Figuren zeigen ein Herstellungsverfahren für keramische Vielschichtbauelemente an.

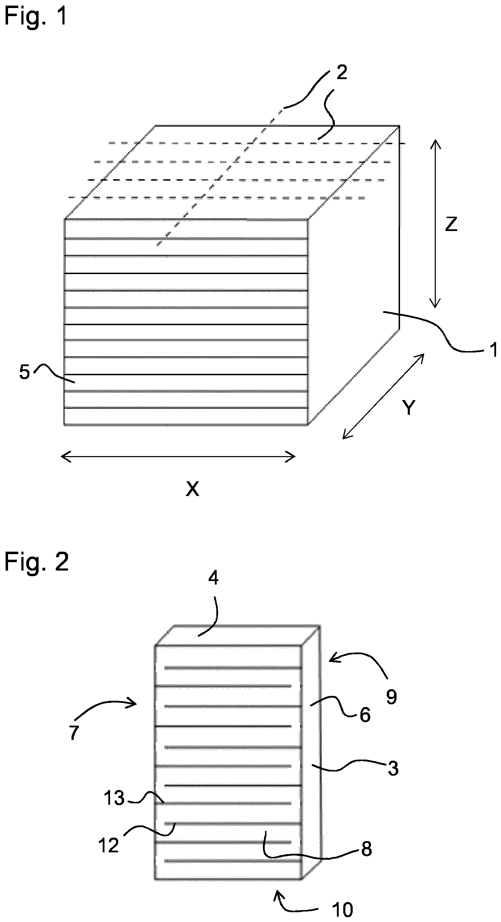

Figur 1 zeigt einen Block 1. Der Block 1 ist vorzugsweise durch Pressen eines Stapels aus aufeinander geschichteten und mit elektrisch leitfähigen Schichten versehenen Grünschichten 5 gebildet oder hergestellt worden. Die Stapelrichtung entspricht der Richtung Z in Figur 1. Dazu sind die Grünschichten 5 vorzugsweise vorher bereitgestellt und vorzugsweise jeweils mit mindestens einer der elektrisch leitfähigen Schichten versehen worden. Die Grünschichten 5 können Folien für eine herzustellende Keramik oder Keramikschicht sein. Die elektrisch leitfähigen Schichten können, beispielsweise durch Siebdruck, auf die Keramikfolien gedruckt werden. Im fertigen Vielschichtbauelement bilden die elektrisch leitfähigen Schichten Innenelektroden.

Nach dem Stapeln der mit elektrisch leitfähigen Schichten versehenen Grünschichten 5 befindet sich vorzugsweise zwischen zwei benachbarten Grünschichten 5 mindestens eine elektrisch leitfähige Schicht.

Der Block 1 weist eine Längsrichtung X auf. Die Längsrichtung X ist senkrecht zur Stapelrichtung Z.

Der Block 1 wird nach dem Pressen in Teilblöcke 3 vereinzelt. Ein solcher Teilblock 3 ist in Figur 2 dargestellt. Die Konturen der Teilblöcke 3 sind in Figur 1 durch Schnitte oder Schnittrichtungen 2 angedeutet. Bei dem Vereinzeln handelt es sich vorzugsweise um Schneiden des Blocks 1 in Teilblöcke 3.

Die Schnitte 2 erfolgen während des Vereinzelns vorzugsweise parallel und senkrecht zur Längsrichtung X. Insbesondere bedeutet "senkrecht zur Längsrichtung X" vorzugsweise quer zur Längsrichtung. Die Richtung senkrecht zur Längsrichtung wird als Y-Richtung bezeichnet. Senkrecht oder quer zur Längsrichtung X wird der Block 1 vorzugsweise nur einmal geschnitten. Alternativ kann der Block 1 quer zur Längsrichtung X mehrfach geschnitten werden. Die Anzahl der Teilblöcke 3, welche quer zur Längsrichtung X geschnitten wurden, kann zwischen zwei und zehn liegen. Es ist auch möglich keinen Schnitt senkrecht oder quer zur Längsrichtung X vorzunehmen.

In Längsrichtung X wird der Block 1 vorzugsweise vielfach (in der Figur 1 beispielsweise viermal) geschnitten. Dabei verlaufen die Schnitte 2 parallel zur Längsrichtung X. Die Anzahl der Teilblöcke 3, welche in Längsrichtung X geschnitten wurden, kann beispielsweise zwischen zwei und 50 liegen. Der Block 1 wird bei dem Vereinzeln durch Schnitte 2 in Längsrichtung X vorzugsweise öfter geschnitten als durch Schnitte 2 in Y-Richtung. Die Schnittflächen der Teilblöcke 3 erfüllen dabei bevorzugt bereits die Anforderungen an die gewünschte Oberflächenqualität, beispielsweise in Bezug auf die Rauigkeit.

Figur 2 zeigt einen Teilblock 3 oder Riegel beispielhaft für eine Vielzahl der aus dem Block 1 vereinzelten Teilblöcke 3.

Das vorgestellte Verfahren umfasst weiterhin nach dem Vereinzeln des Blocks 1 in die Teilblöcke 3 das thermische Behandeln der Teilblöcke 3. Das thermische Behandeln kann ein Entkohlen der Teilblöcke 3 zum Austreiben von Kohlenstoff aus den Teilblöcken 3, beispielsweise in einer sauerstoffarmen Atmosphäre, umfassen. Die sauerstoffarme Atmosphäre kann eine Atmosphäre mit reduziertem Sauerstoffpartialdruck sein. Durch einen reduzierten Sauerstoffpartialdruck kann insbesondere eine Oxidation der elektrisch leitfähigen Schichten, welche beispielsweise aus Kupfer (Cu) sind, verhindert oder eingeschränkt werden. Vorzugsweise nach dem Entkohlen umfasst das thermische Behandeln eine Sinterung der Grünschichten zu keramischen Schichten.

Durch die thermische Behandlung können die Grünschichten zu keramischen Schichten mit dazwischen angeordneten elektrisch leitfähigen Schichten 12, 13 gewandelt werden. Insbesondere weist jeder Teilblock 3 nach der thermischen Behandlung abwechselnd gestapelte keramische Schichten und elektrisch leitfähige Schichten 12, 13 auf, wobei sich ferner in Stapelrichtung Z erste elektrisch leitfähige Schichten 12 und zweite elektrisch leitfähige Schichten 13 abwechseln. Die ersten elektrisch leitfähigen Schichten 12 reichen bis zu einer dritten Seitenfläche 6 des jeweiligen Teilblocks 3 und sind von einer vierten Seitenfläche 7 des jeweiligen Teilblocks 3 beabstandet. Ferner reichen die zweiten elektrisch leitfähigen Schichten 13 bis zu einer vierten Seitenfläche 7 des jeweiligen Teilblocks 3 und sind von einer dritten Seitenfläche 6 des jeweiligen Teilblocks 3 beabstandet.

Das Verfahren umfasst weiterhin, vorzugsweise nach dem thermischen Behandeln, das mechanische Bearbeiten von einer Oberseite 4 und einer Unterseite 10 und/oder das mechanische Bearbeiten von Seitenflächen 6, 7, 8, 9 der Teilblöcke 3. Die Flächennormalen der Oberseite 4 und der Unterseite 10 der Teilblöcke 3 sind dabei parallel zur Stapelrichtung Z. Dementsprechend liegen sich die Oberseite 4 und die Unterseite 10 in Stapelrichtung Z gegenüber. Die Seitenflächen 6, 7, 8, 9 sind diejenigen Außenseiten des Teilblocks, deren Flächennormale senkrecht zur Stapelrichtung ist. Die dritte und die vierte Seitenfläche 6, 7 liegen sich in Längsrichtung X gegenüber. Die erste und die zweite Seitenfläche 8, 9 liegen sich in der Y-Richtung gegenüber.

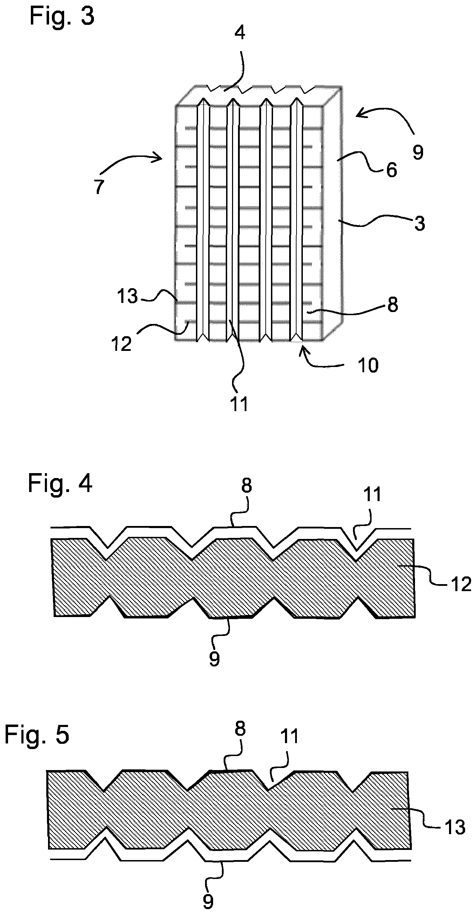

Figur 3 zeigt einen Teilblock nach dem Schritt des mechanischen Bearbeitens der Oberflächen. Der Schritt des mechanischen Bearbeitens kann insbesondere ein Schleifen der Oberflächen aufweisen. Bei den Oberflächen handelt es sich insbesondere um die Oberflächen der Seitenflächen 6, 7, 8, 9. Die Oberflächen der Seitenflächen 6, 7, 8, 9 werden abgeschliffen. Zusätzlich werden Vertiefungen 11 in den Oberflächen der ersten und der zweiten Seitenfläche 8, 9 erzeugt. Diese Vertiefungen 11 erstrecken sich in Stapelrichtung Z, also senkrecht zur Längsrichtung X entlang der Seitenflächen 8, 9. Die Vertiefungen 11 können v-förmig sein.

Die Vertiefungen 11 sind entlang den Schnittlinien 2 angebracht, entlang denen in einem späteren Verfahrensschritt die Teilblöcke 3 vereinzelt werden. Die Vertiefungen 11 werden durch Schleifen erzeugt. Insbesondere können die Vertiefungen 11 in dem gleichen Verfahrensschritt erzeugt werden, in dem auch die Oberflächen der Seitenflächen 6, 7, 8, 9 abgeschliffen werden.

Ferner können auch die Oberflächen der Oberseite 4 und der Unterseite 10 mechanisch bearbeitet werden, beispielsweise mittels Abschleifen. Es können auch auf den Oberflächen der Oberseite 4 und der Unterseite 10 des Teilblocks 3 Vertiefungen 11 erzeugt werden, diese sind jedoch in dem in Figur 3 gezeigten Ausführungsbeispiel nicht vorgesehen. Die Vertiefungen 11 auf der Ober- und Unterseite 4, 10 können sich in Y-Richtung erstrecken, d.h. senkrecht zur Längsrichtung X und senkrecht zur Stapelrichtung Z. Auch die Vertiefungen 11 auf den Oberflächen der Oberseite 4 und der Unterseite 10 können an den Orten vorgesehen werden, entlang denen die Schnitte 2 für das spätere Vereinzeln der Teilblöcke 3 verlaufen.

Durch die Vertiefungen 11 wird eine Profilierung der Teilblöcke 3 erreicht.

Anschließend wird jeder der einzelnen Teilblöcke 3 selektiv geätzt. Dabei wird ein Teil der elektrisch leitfähigen Schichten 12, 13 auf jeweils einer Seitenfläche 8, 9 des Teilblocks 3 abgetragen. Für das selektive Ätzen wird jeder Teilblock 3 zunächst mit einer ersten Hilfselektrode (nicht gezeigt), die mit den ersten leitfähigen Schichten 12 verbunden ist, und mit einer zweiten Hilfselektrode (nicht gezeigt), die mit den zweiten leitfähigen Schichten 13 verbunden ist, versehen. Die Hilfselektroden werden jeweils auf den in Längsrichtung X gegenüberliegenden Seitenflächen 6, 7 aufgebracht.

Nunmehr wird ein Ätzmedium auf zumindest einen Teil des Teilblocks 3 aufgebracht. Insbesondere wird das Ätzmedium auf die erste Seitenfläche 8 und die in der ersten Seitenfläche 8 erzeugten Vertiefungen 11 aufgebracht. Dann wird eine Spannung zwischen der ersten und der zweiten Hilfselektrode angelegt, wodurch ein Materialabtrag aus wenigstens einer der ersten oder der zweiten elektrisch leitfähigen Schicht 12, 13 erfolgt. Der Teilblock 3 kann beispielsweise in ein Ätzmedium teilweise eingetaucht werden, um das Ätzmedium aufzubringen. Anschließend wird auf der zweiten Seitenfläche 9 und in den Vertiefungen 11 in der zweiten Seitenfläche 9 das Ätzmedium aufgebracht und es wird zwischen der ersten und der zweiten Hilfselektrode eine entgegengesetzt gepolte Spannung angelegt, so dass nunmehr Material der jeweils anderen von den ersten oder den zweiten elektrisch leitfähigen Schichten 12, 13 auf der zweiten Seitenfläche 9 und in den Vertiefungen 11 in der zweiten Seitenfläche 9 abgetragen wird.

Figur 4 zeigt einen Querschnitt durch einen Teilblock 3, wobei der Querschnitt in einer Ebene vorgenommen ist, in der sich eine erste leitfähige Schicht 12 befindet. Das Material der ersten elektrisch leitfähigen Schicht 12 wurde auf der ersten Seitenfläche 8 sowie in den Vertiefungen 11 in der ersten Seitenfläche abgetragen. Dementsprechend reicht die erste elektrisch leitfähige Schicht 12 hier nicht bis zur ersten Seitenfläche 8 des Teilblocks 3.

Figur 5 zeigt einen Querschnitt durch eine Ebene, die zu der in Figur 4 gezeigten Ebene benachbarten ist und in der sich eine zweite elektrisch leitfähige Schicht 13 befindet. Hier wurde das Material der zweiten elektrisch leitfähigen Schicht 13 auf der zweiten Seitenfläche 9 und in den Vertiefungen 11 in der zweiten Seitenfläche 9 abgetragen.

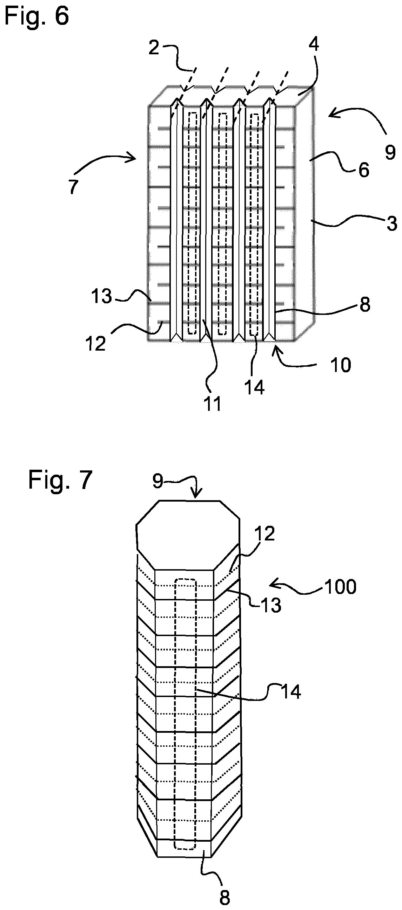

Figur 6 veranschaulicht das Vereinzeln der Teilblöcke 3 quer zur Längsrichtung X in einzelne keramische Vielschichtbauelemente.

Nach dem selektiven Ätzen und vor dem Vereinzeln wurde jeder einzelne Teilblock 3 mit Außenelektroden 14 versehen. Die Außenelektroden 14 werden vorzugsweise auf der ersten und der zweiten Seitenfläche 8, 9 der Teilblöcke 3 angebracht oder abgeschieden.

Durch das oben beschriebene selektive Ätzen sind die Teilblöcke 3 nunmehr derart gestaltet, dass auf der ersten Seitenfläche 8 nur die zweiten elektrisch leitfähigen Schichten 13 bis zur ersten Seitenfläche 8 ragen und auf der zweiten Seitenfläche 9 nur die ersten elektrisch leitfähigen Schichten 12 bis zur zweiten Seitenfläche 9 ragen. Bei dem Versehen der Teilblöcke 3 mit Außenelektroden 14 werden daher jeweils auf den Seitenflächen 8 und 9 nur jede zweite elektrisch leitfähige Schicht 12, 13 mit der jeweiligen Außenelektrode 14 kontaktiert und/oder elektrisch leitfähig verbunden wird.

Die Teilblöcke 3 werden entlang der Schnitte 2 vereinzelt. Das Vereinzeln erfolgt durch ein Schneiden der Teilblöcke. Die Schnittflächen erfüllen dabei bevorzugt bereits die Anforderungen an die gewünschte Oberflächenqualität, beispielsweise in Bezug auf die Rauigkeit.

Figur 7 zeigt ein Vielschichtbauelement 100, das durch das Vereinzeln des Teilblocks 3 gefertigt wurde.

Durch das Vereinzeln der Teilblöcke 3 entstehen Vielschichtbauelemente 100 mit einer Grundfläche, die die Form eines Rechtecks mit abgeschnittenen Ecken aufweist. Die abgeschnittenen Ecken sind dabei durch die Vertiefungen 11 in dem Teilblock 3 bedingt. Die ersten leitfähigen Schichten 12 reichen auf der zweiten Seitenfläche 9, in den abgeschnittenen Ecken, die an die zweite Seitenfläche 9 angrenzen, und entlang der Schnittflächen bis zur Außenseite der Grundfläche. Auf der ersten Seitenfläche 8 und in den an die erste Seitenfläche 8 angrenzenden Ecken reichen sie nicht bis zur Außenseite der Grundfläche. Aus diesem Grund sind die ersten leitfähigen Schichten 12 in der perspektivischen Darstellung der Figur 7 durch gepunktete Linien angedeutet.

Ferner reichen die zweiten leitfähigen Schichten 13 auf der ersten Seitenfläche 8, in den abgeschnittenen Ecken, die an die erste Seitenfläche 8 angrenzen, und entlang der Schnittflächen 2 bis zur Außenseite der Grundfläche. Auf der zweiten Seitenfläche 9 und in den an die zweite Seitenfläche 9 angrenzenden Ecken reichen sie nicht bis zur Außenseite der Grundfläche.

Nach dem Vereinzeln ist eine thermische und/oder mechanische Behandlung der Seitenflächen 6, 7, 8, 9 des keramischen Vielschichtbauelements 100 nicht mehr erforderlich.

Nach dem Vereinzeln der Teilblöcke in die keramischen Vielschichtbauelemente 100 kann das Verfahren weitere Prozessschritte zur endgültigen Fertigstellung der einzelnen keramischen Vielschichtbauelemente 100 umfassen.

Das vorgestellte Verfahren kann bei der Herstellung von vielschichtigen piezoelektrischen Aktuatoren mit Cu-Innenelektroden angewandt werden. Weiterhin können auch Bauelemente oder Aktuatoren mit anderen Elektrodentypen z.B. aus Ag oder AgPd auf die gleiche Weise prozessiert oder hergestellt werden.

Auch kann diese Technologie bei anderen Produkten angewandt werden, z.B. bei vielschichtigen Keramikkondensatoren, wobei die vielschichtigen Bauteile oder Vielschichtbauelemente über viele Prozessschritte als ein Teil des Blocks oder als ein ganzer Block und nicht vereinzelt bearbeitet werden.

### Bezugszeichenliste

- 1: Block
- 2: Schnitt oder Schnittrichtung
- 3: Teilblock
- 4: Oberseite
- 5: Grünschicht
- 6: dritte Seitenfläche
- 7: vierte Seitenfläche
- 8: erste Seitenfläche
- 9: zweite Seitenfläche
- 10: Unterseite
- 11: Vertiefung
- 12: erste elektrisch leitfähige Schicht
- 13: zweite elektrisch leitfähige Schicht
- 14: Außenelektrode
- 100: Vielschichtbauelement
- X: Längsrichtung
- Y: Y-Richtung
- Z: Stapelrichtung

## Patentansprüche

1. Verfahren zur Herstellung von keramischen Vielschichtbauelementen (100) umfassend die folgenden Schritte:
- Bereitstellen von Grünschichten (5) für die keramischen Vielschichtbauelemente (100),
- Stapeln der Grünschichten (5) zu einem Stapel und anschließendes Pressen des Stapels zu einem Block (1),
- Vereinzeln des Blocks (1) in Teilblöcke (3) mit jeweils einer Längsrichtung (X),
- thermisches Behandeln der Teilblöcke (3) und anschließendes mechanisches Bearbeiten von Oberflächen der Teilblöcke (3), wobei bei dem mechanischen Bearbeiten Vertiefungen (11) an den Oberflächen der Teilblöcke (3) gefertigt werden,
- Vereinzeln der Teilblöcke (3).

2. Verfahren gemäß Anspruch 1,
wobei die Teilblöcke (3) entlang der Vertiefungen (11) vereinzelt werden.

3. Verfahren gemäß einem der vorherigen Ansprüche, wobei die bei dem mechanischen Bearbeiten erzeugten Vertiefungen (11) sich in eine Richtung quer zu der Längsrichtung (X) erstrecken.

4. Verfahren gemäß einem der vorherigen Ansprüche,
wobei bei dem mechanischen Bearbeiten die Vertiefungen (11) in den Oberflächen der Teilblöcke (3) durch Schleifen erzeugt werden.

5. Verfahren gemäß einem der vorherigen Ansprüche,
wobei bei dem mechanischen Bearbeiten die Oberflächen der Teilblöcke (3) flächig abgeschliffen werden und im gleichen Verfahrensschritt die Vertiefungen (11) in den Oberflächen der Teilblöcke (3) durch Schleifen erzeugt werden.

6. Verfahren gemäß einem der vorherigen Ansprüche,
wobei die Grünschichten (5) nach dem thermischen Behandeln in jedem Teilblock (3) übereinander angeordnete keramische Schichten und dazwischen angeordnete erste und zweite elektrisch leitfähige Schichten (12, 13) ausbilden,
wobei die Teilblöcke (3) nach dem mechanischen Bearbeiten der Oberflächen selektiv geätzt werden, und wobei Material von den ersten elektrisch leitfähigen Schichten (12) auf einer ersten Seitenfläche (8) des Teilblocks (3) und in den in der ersten Seitenfläche (8) gefertigten Vertiefungen (11) bei dem selektiven Ätzen abgetragen wird und Material von den zweiten elektrisch leitfähigen Schichten (13) auf einer zweiten Seitenfläche (9) des Teilblocks (3) und in den in der zweiten Seitenfläche gefertigten Vertiefungen (11) bei dem selektiven Ätzen abgetragen wird.

7. Verfahren gemäß einem der vorherigen Ansprüche,
wobei die Vertiefungen (11) V-förmig sind.

## Claims

1. Method for producing ceramic multilayer components (100), comprising the following steps:
- providing green layers (5) for the ceramic multilayer components (100),
- stacking the green layers (5) to form a stack and subsequently pressing the stack to yield a block (1),
- singulating the block (1) into sub-blocks (3) in each case with a longitudinal direction (X),
- heat-treating the sub-blocks (3) and subsequently machining surfaces of the sub-blocks (3), wherein during the machining depressions (11) are made in the surfaces of the sub-blocks (3),
- singulating the sub-blocks (3).

2. Method according to claim 1,
wherein the sub-blocks (3) are singulated along the depressions (11).

3. Method according to one of the preceding claims,
wherein the depressions (11) produced during the machining extend in a transverse direction relative to the longitudinal direction (X).

4. Method according to one of the preceding claims,
wherein during machining the depressions (11) are produced in the surfaces of the sub-blocks (3) by grinding.

5. Method according to one of the preceding claims,
wherein during machining the surfaces of the sub-blocks (3) are ground off flat and in the same method step the depressions (11) are produced in the surfaces of the sub-blocks (3) by grinding.

6. Method according to one of the preceding claims,
wherein after heat treatment the green layers (5) form ceramic layers arranged one above the other in each sub-block (3) and first and second electrically conductive layers (12, 13) arranged therebetween,
wherein the sub-blocks (3) are selectively etched after machining of the surfaces, and wherein material is removed during the selective etching from the first electrically conductive layers (12) on a first side face (8) of the sub-block (3) and in the depressions (11) made in the first side face (8) and material is removed during the selective etching from the second electrically conductive layers (13) on a second side face (9) of the sub-block (3) and in the depressions (11) made in the second side face.

7. Method according to one of the preceding claims,
wherein the depressions (11) are V-shaped.

## Revendications

1. Procédé pour la préparation de composants multicouches céramiques (100), comprenant les étapes suivantes :
- mise à disposition de couches crues (5) pour les composants multicouches céramiques (100),
- empilement des couches crues (5) en une pile et compression consécutive de la pile en un bloc (1),
- séparation du bloc (1) en blocs partiels (3) présentant chacun une direction longitudinale (X),
- traitement thermique des blocs partiels (3) et usinage mécanique consécutif de surfaces des blocs partiels (3), des creux (11) étant réalisés au niveau des surfaces des blocs partiels (3) lors de l'usinage mécanique,
- séparation des blocs partiels (3).

2. Procédé selon la revendication 1,
les blocs partiels (3) étant séparés le long des creux (11).

3. Procédé selon l'une quelconque des revendications précédentes,
les creux (11) réalisés lors de l'usinage mécanique s'étendant dans une direction transversale à la direction longitudinale (X).

4. Procédé selon l'une quelconque des revendications précédentes, les creux (11) dans les surfaces des blocs partiels (3) étant réalisés par meulage lors de l'usinage mécanique.

5. Procédé selon l'une quelconque des revendications précédentes,
les surfaces des blocs partiels (3) étant polies de manière plane pendant l'usinage mécanique et les creux (11) dans les surfaces des blocs partiels (3) étant réalisés par meulage au cours de la même étape de procédé.

6. Procédé selon l'une quelconque des revendications précédentes,
les couches crues (5) formant, après le traitement thermique, dans chaque bloc partiel (3), des couches céramiques superposées et des premières et deuxièmes couches électriquement conductrices (12, 13) disposées entre celles-ci,
les blocs partiels (3) étant gravés sélectivement après l'usinage mécanique des surfaces et le matériau des premières couches électriquement conductrices (12) étant éliminé sur une première surface latérale (8) du bloc partiel (3) et dans les creux (11) réalisés dans la première surface latérale (8) lors de la gravure sélective et le matériau des deuxièmes couches électriquement conductrices (13) étant éliminé sur une deuxième surface latérale (9) du bloc partiel (3) et dans les creux (11) réalisés dans la deuxième surface latérale lors de la gravure sélective.

7. Procédé selon l'une quelconque des revendications précédentes, les creux (11) étant en forme de V.
